# FASCICULE DE BREVET EUROPEEN

(11) **EP 0 987 713 B1**
(45) Date de publication et mention de la délivrance du brevet: **02.03.2005**
(21) Numéro de dépôt: 99410112.9
(22) Date de dépôt: 14.09.1999
(51) Int. Cl.: G11C 5/02, G11C 7/00

(54) **Architecture de circuit mémoire**
Architektur einer Speicherschaltung
Memory circuit architecture

(30) Priorité: 16.09.1998 FR 9811715
(43) Date de publication de la demande: 22.03.2000
(73) Titulaire: STMicroelectronics S.A., 92120 Montrouge (FR)
(72) Inventeur: Ferrant, Richard, 38330 Saint Ismier (FR)
(74) Mandataire: de Beaumont, Michel

(56) Documents cités:
- EP-A- 0 771 006
- US-A- 5 097 440
- US-A- 5 499 215

## Description

La présente invention concerne les mémoires réalisées sous la forme d'un réseau matriciel de cellules mémoire en circuit intégré. L'invention s'applique par exemple aux mémoires dynamiques (DRAM), qui stockent les données (états "0" ou "1") à mémoriser dans des cellules mémoire constituées chacune d'un condensateur de stockage et d'un transistor MOS de sélection. On se référera ci-après à l'exemple d'une mémoire dynamique. On notera toutefois que l'invention concerne également d'autres types de mémoire, par exemple, des mémoires statiques (SRAM) ou des EPROM et, plus généralement, tout réseau matriciel de cellules.

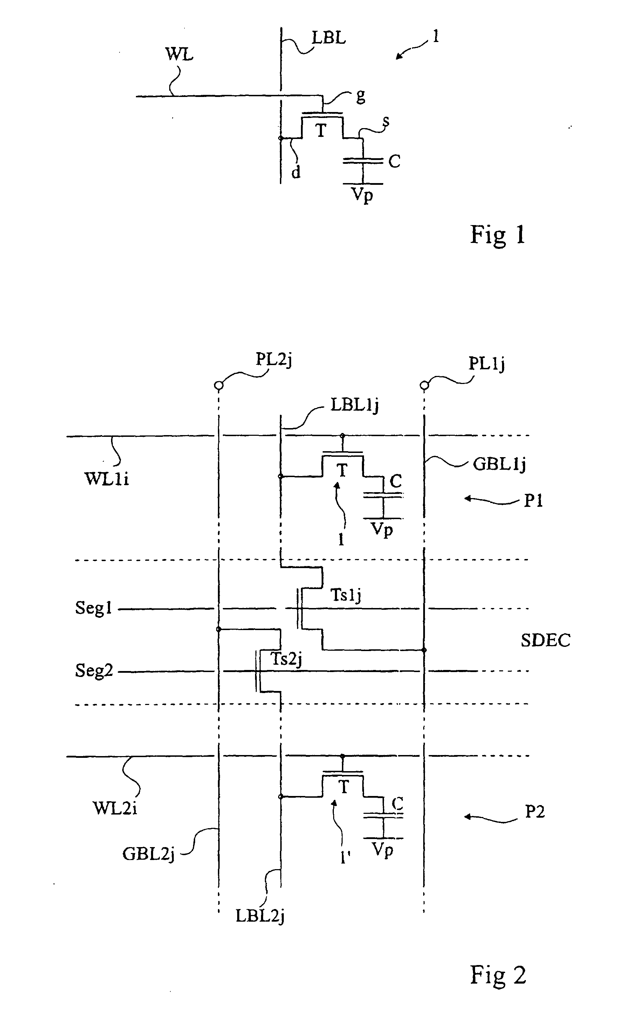

La figure 1 représente, de façon très schématique, un exemple de cellule 1 d'une mémoire dynamique (DRAM) classique. Une telle cellule 1 est constituée d'un transistor MOS T de sélection (ici, par exemple, un transistor à canal N) associé à un condensateur C de stockage de la donnée à mémoriser. La grille g du transistor T est reliée à une ligne de rangée WL, dite ligne de mot. Le drain d du transistor T est relié à une ligne de colonne LBL, dite ligne de bit locale. La source s du transistor T est reliée à une première borne du condensateur C dont l'autre borne est connectée à une tension constante Vp, généralement un potentiel (Vdd/2) médian entre les potentiels haut Vdd et bas Vss (généralement la masse) d'alimentation. La borne s constitue le noeud de stockage de la donnée de la cellule mémoire ainsi constituée. Plusieurs cellules mémoire telles que celle représentée à la figure 1 sont associées dans un réseau matriciel de rangées de mot et de colonnes de bit.

Pour qu'une cellule 1 telle que représentée à la figure 1 soit adressée, il faut que la ligne de mot WL associée à la grille du transistor T de cette cellule soit portée à un potentiel haut, généralement le potentiel haut Vdd d'alimentation du réseau matriciel.

Si cet adressage est lié à une écriture, le noeud s de stockage est alors placé soit au potentiel bas (Vss) d'alimentation du réseau matriciel si le condensateur C est déchargé par l'intermédiaire d'une ligne de bit LBL connectée à la masse, soit au potentiel Vdd si la ligne de bit LBL est placée au potentiel Vdd signifiant une programmation à l'état haut. Pour simplifier l'exposé, les niveaux décrits ci-dessus ne tiennent pas compte de l'influence de la tension seuil Vt du transistor T sur le niveau mémorisé dans le condensateur C.

Si la cellule 1 est adressée en lecture, la ligne de bit locale LBL est préchargée à un potentiel médian (Vdd/2) entre les deux potentiels d'alimentation haut Vdd et bas Vss du circuit. L'état "0" ou "1" mémorisé est alors déterminé en comparant le potentiel de la ligne de bit LBL, modifié en fonction de la charge du condensateur C, par rapport à une ligne de bit de référence, également préchargée à un niveau Vdd/2 mais ne subissant pas l'influence du condensateur de stockage.

La figure 2 illustre, de façon très schématique, l'utilisation des lignes de bit de référence dans une mémoire dynamique dite "ouverte" (open), dans laquelle les lignes de référence proviennent d'un réseau de cellules mémoire voisin mais distinct du réseau où se trouve la cellule adressée, par opposition aux mémoires dites "repliées" (folded) où la ligne de référence d'une cellule adressée est constituée par la ligne de bit voisine de cette cellule. La présente invention s'applique cependant aussi aux mémoires repliées comme on le verra par la suite.

Dans une telle architecture de mémoire, un premier plan ou section P1 de cellules 1 du type de celle représentée à la figure 1 est séparé d'un deuxième plan mémoire P2 contenant le même type de cellules élémentaires 1'. Chaque plan P1, P2 constitue à lui seul un réseau matriciel de cellules mémoire indépendant de l'autre, dans le sens qu'il est adressable par des lignes de mot WL1, WL2 différentes. Côté lignes de bit, chaque plan mémoire possède ses propres lignes de bit locales LBL1 et LBL2, mais partage les amplificateurs de lecture/écriture, ou de décodage de colonne, (non représentés en figure 2) avec l'autre plan mémoire. Par la suite, on parlera d'amplificateur de lecture ou de décodeur de colonne. En pratique, chaque ligne de bit locale LBL1ⱼ ou LBL2ⱼ de chaque plan mémoire P1, P2 est connectée, par l'intermédiaire d'un transistor de sélection de section Ts1ⱼ, Ts2ⱼ, à une ligne de bit globale GBL1, GBL2 respectivement. Les lignes de bit globales GBL1ⱼ et GBL2ⱼ correspondant à des colonnes de même rang j dans les deux plans mémoire P1 et P2 partagent toutefois un même amplificateur de décodage de colonne, une des deux lignes servant de référence à l'autre. Par conséquent, les plans mémoire P1 et P2 ne sont pas adressés simultanément en lecture (c'est d'ailleurs pourquoi ils sont respectivement associés à des lignes de mot différentes), chaque plan jouant à tour de rôle, le rôle de plan de référence pour les cellules mémoire lues dans l'autre plan mémoire.

Par souci de simplification, les plans mémoire P1 et P2 n'ont pas été représentés de façon intégrale à la figure 2. On s'est contenté de représenter une cellule pour chaque plan et le transistor de décodage de section associé à la ligne de bit locale correspondante. Le rang des lignes de mot à été désigné par l'indice i tandis que le rang des lignes de bit a été désigné par l'indice j.

Les transistors Ts1ⱼ et Ts2ⱼ de sélection de section reçoivent, sur leur grilles respectives, des signaux de commande Seg1 et Seg2 qui sont activés simultanément.

En supposant une lecture de la cellule 1 à l'intersection des lignes WL1ᵢ et LBL1ⱼ, le transistor T de sélection de cette cellule est rendu conducteur, de même que le transistor Ts1ⱼ de sélection de la section correspondant au plan mémoire P1. La ligne de bit globale GBL2ⱼ sert alors de ligne de bit de référence pour la lecture de la cellule 1 du plan 1, le transistor Ts2ⱼ étant également rendu conducteur de façon à égaliser les éléments parasites. Les lignes de bit globales sont préchargées au niveau Vdd/2 au moyen de dispositifs de précharge (non représentés) connectés, pour l'occasion, à des premières bornes PL1ⱼ, PL2ⱼ d'extrémité des lignes GBL1ⱼ, GBL2ⱼ. Le cas échéant, cette précharge intervient par l'intermédiaire des lignes de bit locales (tous les transistors Ts étant passants le long de la colonne). Comme les deux lignes de bit globales sont préchargées au niveau Vdd/2, le sens de la faible différence (provenant de la capacité C de la cellule décodée) entre leurs niveaux respectifs lors de la lecture détermine l'état de la cellule 1.

On notera que les signaux Seg1 et Seg2 commandent simultanément les transistors de sélection de section Ts1 et Ts2 de toutes les lignes de bit locales du plan mémoire auquel ces signaux de commande sont associés. La sélection de la colonne dans le réseau mémoire s'effectue généralement en aval, c'est-à-dire au niveau des étages d'entrée-sortie de données dans la mémoire. Ces étages (non représentés en figure 2) comprennent notamment des circuits adaptateurs de niveau (buffers).

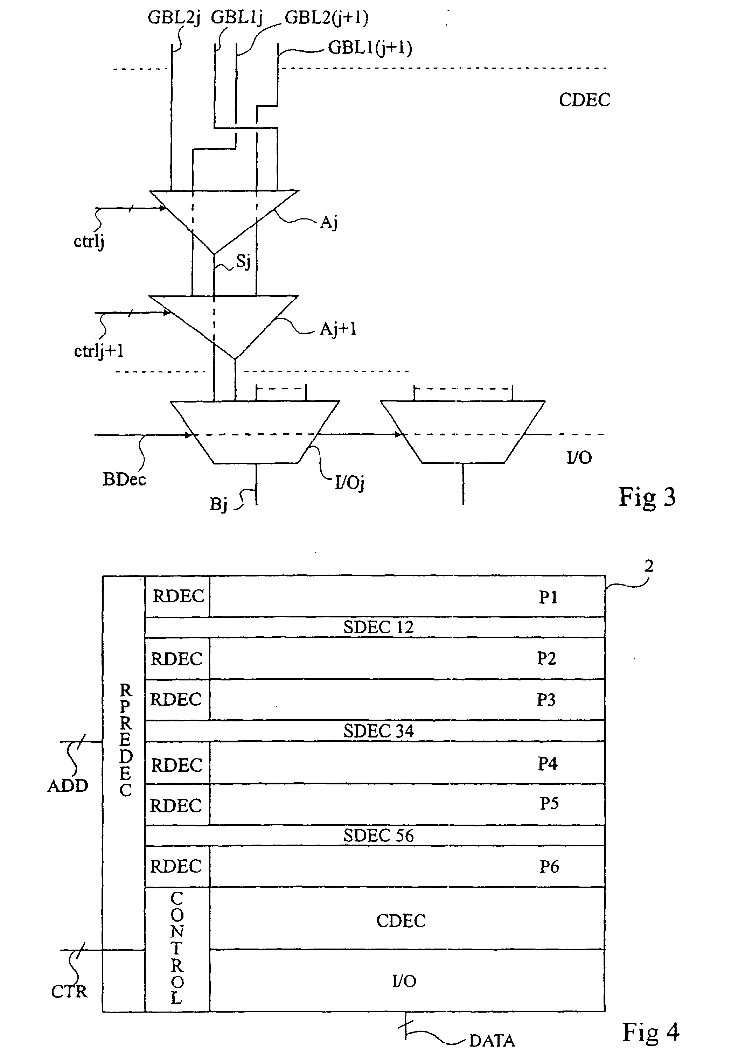

La figure 3 représente, de façon très schématique, un exemple classique d'amplificateur de lecture, ou de décodage de colonne, CDEC et d'étage d'entrée-sortie I/O d'une mémoire à laquelle se rapporte la présente invention.

Chaque paire de lignes de bit globales GBL1ⱼ, GBL2ⱼ, associées pour servir respectivement l'une à l'autre de ligne de bit de référence, est envoyée sur une des deux entrées d'un amplificateur Aⱼ de décodage de colonne, chargé de délivrer, sur une sortie Sⱼ, l'état décodé de la cellule mémoire lue. L'amplificateur Aⱼ reçoit des signaux de commande et d'alimentation désignés sous la référence globale CTRLⱼ. La sortie Sⱼ de l'amplificateur Aⱼ est envoyée, avec les sorties respectives de plusieurs autres amplificateurs de lecture (par exemple, Aⱼ₊₁), sur un étage d'entrée-sortie I/Oⱼ chargé de sélectionner une des entrées qu'il reçoit pour délivrer un seul bit Bⱼ lu. L'étage I/Oⱼ est commandé par un signal de décodage de bit BDec, et est associé à plusieurs autres étages d'entrée-sortie recevant des signaux de sortie d'amplificateurs de lecture différents, chaque étage I/O délivrant un bit d'un mot (par exemple, de 16 bits) de la mémoire.

L'encombrement d'un amplificateur de décodage de colonne Aⱼ d'une mémoire dynamique classique conduit généralement à ce que ces amplificateurs sont alignés deux par deux dans le sens des colonnes de manière à disposer d'une largeur suffisante pour assurer l'ensemble des connexions nécessaires aux transistors constitutifs de ces amplificateurs. Ainsi, à la figure 3, deux amplificateurs Aⱼ et Aⱼ₊₁ ont été représentés alignés dans la direction des colonnes (direction verticale de la figure).

Un problème qui se pose dans la réalisation des mémoires dynamiques est lié au compromis nécessaire entre le rapport signal/bruit reçu par les amplificateurs de décodage de colonne CDEC (figure 3) et le nombre de décodeurs de section SDEC (figure 2), donc de plans mémoire P nécessaires. En effet, plus on souhaite un rapport signal/bruit élevé pour les amplificateurs de lecture, plus on doit multiplier le nombre de plans mémoire et, par voie de conséquence, le nombre de décodeurs de section et d'amplificateurs de lecture/écriture.

On peut considérer que les variations du rapport signal/bruit sont essentiellement liées aux capacités mises en jeu. Lors de la lecture d'une cellule mémoire, deux capacités "parasites" interviennent en plus du condensateur C de la cellule. Il s'agit d'une part de la ligne de bit globale GBL sur laquelle vient se raccorder la ligne de bit locale LBL de la cellule lue et qui présente généralement une capacité de l'ordre de 450 fF. Une deuxième capacité parasite provient de la ligne de bit locale LBL de la cellule concernée et dépend du nombre de cellules raccordées sur le transistor Ts du décodeur de section correspondant. Classiquement, pour 64 cellules raccordées par section, cette capacité de ligne de bit locale est de l'ordre de 150 fF. Ces capacités parasites sont à comparer à la capacité du condensateur C de la cellule qui est, par exemple, de l'ordre de 35 fF. Une telle capacité de 35 fF correspond à une capacité de cellule mémoire dynamique réalisée en technologie HCMOS6 et d'une taille correspondant à la taille minimale réalisable dans ce type de technologie. En effet, la capacité du condensateur C de la cellule mémoire est liée à sa taille que l'on cherche la plus faible possible pour minimiser la taille des mémoires en circuit intégré.

Il n'est donc pas rare de voir des rapports signal/bruit inférieurs à 1/15, ce qui entraîne un besoin de disposer d'amplificateurs de lecture Aⱼ très performants et, par voie de conséquence, comportant un nombre relativement élevé de transistors (de l'ordre d'une trentaine de transistors par amplificateur).

En outre, à partir d'un certain seuil de rapport signal/bruit, donc de nombre de sections pour un même amplificateur, on est contraint de partitionner la mémoire en multipliant le nombre d'amplificateurs.

Pour ne pas altérer davantage le rapport signal/bruit, on ne souhaite pas classiquement augmenter le nombre de cellules par section.

Toutefois, un inconvénient des décodeurs de section est qu'ils prennent de la place et qu'ils nécessitent des signaux de commande. De plus, tous les décodeurs de section doivent être commandés simultanément lors de la précharge des lignes de bit globales. Une telle commande entraîne un besoin de courant relativement important par rapport au courant nécessaire à l'adressage d'une ligne de mot. Une conséquence est que cela prend du temps au niveau d'un circuit de pompe de charge pour fournir le courant suffisant, sauf à surdimensionner celui-ci et nuire alors à l'encombrement de la mémoire.

L'espace nécessaire à la réalisation des décodeurs de section et des amplificateurs de décodage de colonne conditionne, pour l'essentiel avec l'encombrement des plans mémoire eux-mêmes, l'encombrement global de la mémoire en circuit intégré.

La figure 4 illustre, de façon très schématique, la disposition des différents éléments constitutifs d'une mémoire dynamique en circuit intégré du type auquel s'applique la présente invention. La représentation de la figure 4 indique les zones dans lesquelles sont implantés les différents constituants de la mémoire sur une puce 2 en circuit intégré.

Par souci de simplification, seuls six plans mémoire P1, P2, P3, P4, P5, P6 ont été représentés à la figure 4. On notera que, en pratique, le nombre de plans mémoire est beaucoup plus important (de l'ordre de 16, 32 et plus). À une extrémité des lignes de mot (non représentées à la figure 4) de chaque plan mémoire, un décodeur de rangée RDEC, associé au plan mémoire concerné, sélectionne la ligne de mot adressée dans le plan correspondant. Les plans mémoire sont associés deux par deux à un décodeur de section SDEC12, SDEC34, SDEC56 chargé de sélectionner celui des plans mémoire dont les lignes de bit locales doivent servir de référence pour la lecture de l'autre. Les lignes de bit globales issues des différents décodeurs de section sont envoyées aux entrées respectives d'amplificateurs de décodage de colonne CDEC dont les sorties respectives sont envoyées aux entrées d'étages d'entrée-sortie I/O.

La structure interne des plans mémoire, des décodeurs de section, des décodeurs de colonne et des étages d'entrée-sortie, ainsi que leur fonctionnement, correspond à la description ci-dessus des figures 1 à 3. Les décodeurs de rangées RDEC sont reliés à un prédécodeur PREDEC recevant un signal d'adresse ADD sur plusieurs bits. Les étages d'entrée-sortie I/O sont reliés à un bus de données DATA sur plusieurs bits et une zone de commande CONTROL du circuit mémoire reçoit des signaux de commande CTR. La zone de commande est implantée physiquement dans un coin de la puce 2, laissé libre après implantation des autres constituants, par exemple, au coin inférieur gauche de la puce comme cela est illustré par la figure 4.

Les plans mémoire et les décodeurs de section constituent ensemble ce que l'on désigne généralement par matrice mémoire. Les autres circuits correspondent aux circuits de décodage et d'entrée-sortie de cette matrice.

Le document US-A-5499215 décrit une mémoire dans laquelle des lignes d'interconnexion, par colonne, d'amplificateurs de lecture (SA) sont reliées, par une extrémité, à un circuit (DA) de sélection de colonne.

Un objet de la présente invention est de proposer une nouvelle architecture de mémoire dynamique qui optimise l'utilisation de l'espace de la puce de circuit intégré.

La présente invention vise également à proposer une mémoire dynamique qui, pour une taille élémentaire de cellules mémoire donnée, soit d'un encombrement réduit par rapport aux mémoires classiques.

La présente invention vise également à minimiser le courant nécessaire au fonctionnement de la mémoire, en particulier, en précharge des lignes de bit lors d'une lecture.

Pour atteindre ces objets, la présente invention prévoit une mémoire en circuit intégré comprenant un réseau matriciel de cellules mémoire divisé en plusieurs sections, et plusieurs rangées d'amplificateurs de décodage de colonne dont les sorties respectives sont interconnectées, par colonne, au moyen d'une ligne de bit décodée, chaque ligne de bit décodée comportant deux tronçons perpendiculaires dont un dans le sens des rangées pour relier directement chaque ligne de bit décodée à une entrée d'un étage d'entrée-sortie de la mémoire situé à une extrémité des rangées.

Selon un mode de réalisation de la présente invention, le changement de direction entre les deux tronçons s'effectue sans élément actif, par interconnexion conductrice directe.

Selon un mode de réalisation de la présente invention, la mémoire comporte une rangée d'amplificateurs de décodage de colonne pour au plus deux sections.

Selon un mode de réalisation de la présente invention, où chaque cellule mémoire est constituée d'un transistor associé à un condensateur de stockage, chaque amplificateur de décodage de colonne est directement relié à une ligne de bit locale interconnectant les drains respectifs des transistors des cellules mémoire d'une section.

Selon un mode de réalisation de la présente invention, tous les circuits d'exploitation des cellules mémoire sont logés dans le même alignement sur le circuit intégré.

Selon un mode de réalisation de la présente invention, tous les circuits d'exploitation des cellules mémoire, à l'exception des amplificateurs de décodage de colonne, sont logés de part et d'autre du circuit intégré, aux extrémités des rangées de cellules mémoire.

Selon un mode de réalisation de la présente invention, tous les circuits d'exploitation des cellules mémoire, à l'exception des amplificateurs de décodage de colonne, sont logés d'un seul côté du circuit intégré, à une extrémité des rangées de cellules mémoire.

Selon un mode de réalisation de la présente invention, tous les bus d'entrée-sortie de la mémoire se trouvent d'un même côté du circuit intégré.

Selon un mode de réalisation de la présente invention, le nombre de rangées de cellules mémoire par section mémoire est choisi pour respecter un rapport signal/bruit en lecture qui soit supérieur à 1/10 en entrée des amplificateurs de décodage de colonne.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 à 4 qui ont été décrites précédemment sont destinées à exposer l'état de la technique et le problème posé ;
la figure 5 représente partiellement un mode de réalisation d'une matrice mémoire selon la présente invention ; et
la figure 6 représente, de façon très schématique, un mode de réalisation d'une mémoire dynamique en circuit intégré selon la présente invention.

Les mêmes éléments ont été désignés par les mêmes références aux différentes figures. Pour des raisons de clarté, seuls les éléments du circuit mémoire qui sont nécessaires à la compréhension de l'invention ont été représentés aux figures et seront décrits par la suite.

Une caractéristique de la présente invention est de prévoir, pour chaque paire de sections ou plans mémoire, associés pour servir alternativement l'un à l'autre de plan de référence, une rangée d'amplificateurs de lecture/écriture, ou amplificateurs de décodage de colonne. Ainsi, selon la présente invention, une mémoire dynamique en circuit intégré, comprenant plusieurs paires de sections mémoire associées deux à deux, comporte plusieurs rangées d'amplificateurs de décodage de colonne et est, par contre, dépourvue de décodeurs de section, les amplificateurs étant implicitement décodés par leurs commandes respectives.

Les plans mémoire d'une mémoire dynamique en circuit intégré selon la présente invention sont, de façon classique, constitués de cellules pourvues, chacune, d'un transistor associé à un condensateur. Chaque plan mémoire comporte des lignes de bit locales reliant, en colonne, les drains des différents transistors dont les grilles respectives sont reliées, en rangée, à des lignes de mot. L'association des sections de cellules mémoire par paire correspond, comme précédemment, à un appariement destiné à utiliser alternativement un plan ou l'autre en plan de référence.

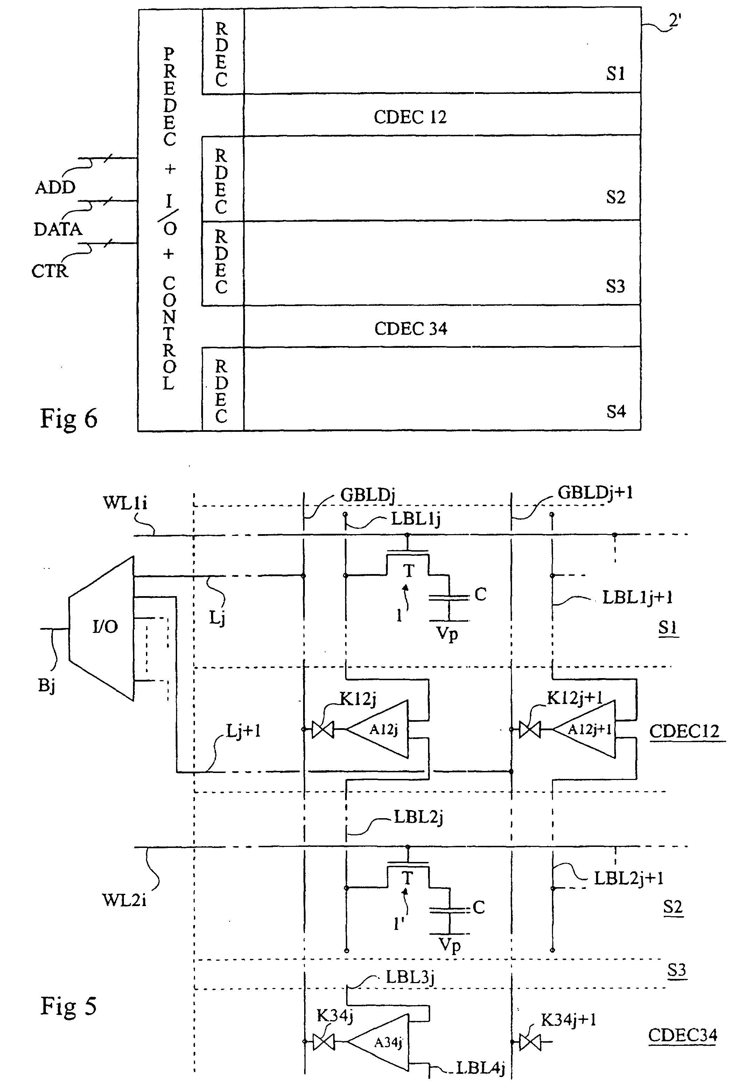

La figure 5 représente, de façon très schématique, l'organisation des amplificateurs de lecture d'une mémoire dynamique en circuit intégré selon un mode de réalisation de la présente invention.

Pour des raisons de clarté, seules deux cellules mémoire 1, 1' ont été détaillées à la figure 5. De même, la représentation de la figure 5 est très partielle dans les deux directions du réseau matriciel. Comme précédemment, on ne fera référence qu'à des amplificateurs de lecture mais on notera qu'il s'agit d'amplificateurs de lecture/écriture.

Comme l'illustre la figure 5, chaque ligne de bit locale LBL1ⱼ, LBL2ⱼ, LBL1ⱼ₊₁, LBL2ⱼ₊₁, LBL3ⱼ, LBL4ⱼ, est reliée à une entrée d'un amplificateur de lecture, ou de décodage de colonne, A12ⱼ, A12ⱼ₊₁, A34ⱼ. Ainsi, des premières extrémités respectives des lignes de bit locales LBL1ⱼ et LBL2ⱼ sont reliées aux deux entrées d'un amplificateur A12ⱼ. Les lignes LBL1ⱼ₊₁ et LBL2ⱼ₊₁ ont chacune une première extrémité reliée à l'amplificateur A12ⱼ₊₁. Les lignes LBL3ⱼ et LBL4ⱼ ont chacune une première extrémité reliée aux entrées d'un amplificateur A34ⱼ. Cette même structure est reproduite dans tout le réseau matriciel.

Les extrémités libres respectives des différentes lignes de bit locales sont individuellement reliées à un dispositif de précharge de lecture (non représenté). Ce dispositif est, de façon classique, destiné à précharger les lignes de bit des plans mémoire devant être lues à un potentiel Vdd/2, intermédiaire entre les deux potentiels Vdd et Vss d'alimentation du circuit mémoire. Une distinction entre la présente invention et l'architecture classique telle que décrite en relation avec la figure 2 est que ce sont les lignes de bit locales et non plus les lignes de bit globales qui sont reliées aux dispositifs de précharge.

Selon la présente invention, on évite le recours à des lignes de bit globales pour véhiculer les signaux de données avant décodage. Toutefois, dans la disposition de la mémoire, on utilise des lignes de bit décodées GBLDⱼ, GBLDⱼ₊₁ qui interconnectent les sorties respectives des amplificateurs de lecture d'une même colonne.

Les signaux de données décodés, présents sur les lignes de bit décodées de l'invention, sont destinés à être reliés aux entrées d'étages d'entrée-sortie I/O qui, de façon classique, sélectionnent une de leurs entrées pour délivrer un bit Bⱼ d'un mot de données lu dans la mémoire.

Le fait, selon l'invention, d'associer un dispositif de précharge à chaque ligne de bit locale permet, sans augmenter la taille unitaire des cellules mémoire 1, 1', d'accroître le nombre de cellules, raccordées sur une même ligne de bit locale et associées à un amplificateur de lecture donné, tout en simplifiant considérablement la constitution (le nombre de transistors) de cet amplificateur de lecture.

En effet, la capacité à prendre en compte dans le rapport signal/bruit en entrée des amplificateurs de lecture est désormais la seule capacité de la ligne de bit locale et non plus la somme de cette capacité avec celle de la ligne de bit globale. La capacité de la ligne de bit globale n'a, selon l'invention, plus d'incidence sur ce rapport signal/bruit dans la mesure où les lignes conductrices servant à former les lignes de bit décodées de l'invention servent à véhiculer des données amplifiées et décodées par les amplificateurs de lecture et qui sont donc en niveaux CMOS. En reprenant l'exemple cité précédemment d'une technologie HCMOS6 dans laquelle la capacité des condensateurs C de stockage est de l'ordre de 35 fF, on peut augmenter la longueur des lignes de bit locales, donc augmenter le nombre de cellules mémoire qui y sont raccordées, jusqu'à atteindre une capacité de l'ordre de 300 fF. Une telle capacité laisse un rapport signal/bruit supérieur à un dixième et permet déjà une simplification considérable des amplificateurs de lecture.

À titre d'exemple particulier de réalisation, en connectant 128 cellules mémoire par ligne de bit locale, on obtient une capacité parasite de ligne locale de l'ordre de 280 fF qui est à rapprocher d'une capacité de 35 fF. Il en découle un rapport signal/bruit de l'ordre de 1/7. Avec un tel rapport signal/bruit, il est alors possible de concevoir un amplificateur de lecture dont le nombre de transistors se limite à une dizaine et dont, par conséquent, la conception (robustesse) est facilitée et l'encombrement est fortement réduit. La réalisation d'un amplificateur de lecture et l'influence du rapport signal/bruit en entrée sur sa complexité est à la portée de l'homme du métier.

Ainsi, si la présente invention conduit à multiplier le nombre d'amplificateurs de lecture par rapport à une mémoire classique, elle les simplifie considérablement. De plus, en supprimant les décodeurs de section nécessaires aux mémoires classiques, on réduit l'augmentation de taille verticale liée à l'utilisation d'une rangée d'amplificateurs de lecture par paire de sections mémoire.

On notera qu'en allongeant les lignes de bit locales, le nombre de rangées d'amplificateurs de lecture (donc de sections mémoire) est inférieur dans une mémoire selon l'invention par rapport à une mémoire classique utilisant des décodeurs de section.

Un avantage de la présente invention est qu'en supprimant les décodeurs de section, on réduit considérablement l'appel de courant lors de la précharge en lecture de la mémoire.

Un autre avantage de la présente invention est qu'en améliorant le rapport signal/bruit des entrées des amplificateurs de lecture, on réduit l'encombrement individuel d'un amplifiateur de lecture. Or, comme on l'a vu précédemment, les amplificateurs de lecture se partagent en pratique entre deux colonnes en raison de leur encombrement (figure 3). Si la réduction d'encombrement apportée par l'invention ne permet pas de réaliser un amplificateur sur une seule colonne dans la mesure où la largeur d'une colonne est définie à partir de la taille individuelle d'un transistor MOS du circuit, la présente invention minimise l'espace en hauteur pris pour la réalisation d'un amplificateur de lecture.

On notera que l'architecture du circuit mémoire de la présente invention respecte parfaitement la sélection de colonne opérée classiquement par les étages d'entrée-sortie. À cet égard, on notera que le nombre d'entrées de chaque étage d'entrée-sortie n'est pas modifié par la mise en oeuvre de la présente invention par rapport à une architecture classique pour une taille de mémoire donnée. En effet, alors que, dans une mémoire classique, l'interconnexion des différentes sections de la mémoire s'effectue en amont des amplificateurs de lecture, cette interconnexion s'effectue, selon l'invention, en aval de ces amplificateurs de lecture mais reste de même nature.

Une autre caractéristique de la présente invention est de tirer profit de la réduction d'encombrement individuel des amplificateurs de lecture et de la suppression des décodeurs de section pour reporter, d'un seul côté de la mémoire, toutes ses entrées-sorties.

La figure 6 représente, de façon très schématique, l'architecture d'une mémoire en circuit intégré selon la présente invention. Cette figure 6 est une vue de dessus d'une puce 2' de mémoire en circuit intégré, réalisée en mettant oeuvre la présente invention. Pour des raisons de clarté, on considère que la mémoire prise pour exemple en figure 6 ne comporte que quatre sections S1, S2, S3, S4 et est donc associée à deux rangées d'amplificateurs de lecture (ou décodeurs de colonne) CDEC12 et CDEC34. On notera qu'en pratique le nombre de rangées d'amplificateurs de lecture est beaucoup plus important.

Selon l'invention telle qu'illustrée par la figure 6, les étages d'entrée-sortie de données sont reportés dans le même alignement, de préférence du même côté de la mémoire que les décodeurs de rangées et le prédécodeur de rangée. Par conséquent, selon l'invention, tous les circuits d'adressage, de décodage, d'amplification et d'entrée-sortie du circuit mémoire sont d'un seul côté de la puce 2' de circuit intégré, du côté d'une extrémité des rangées c'est-à-dire des lignes de mot.

Comme l'illustre la figure 5, les lignes de bit décodées GBLDⱼ, GBLDⱼ₊₁ qui interconnectent les sorties respectives des amplificateurs de lecture sont reliées, par l'intermédiaire de conducteurs Lⱼ, Lⱼ₊₁, aux étages I/O d'entrée-sortie. Les lignes Lⱼ et Lⱼ₊₁ sont parallèles aux lignes de mot WL dans la mesure où, selon l'invention, les étages d'entrée-sortie sont répartis dans la partie gauche de la puce 2' (figure 6). Dans cette partie de la puce, tous les circuits (RDEC, PREDEC, I/O, CONTROL) sont disposés pour que les bus d'adresses ADD, de données DATA et de commande CTR soient tous d'un même côté de la puce 2'.

Une caractéristique de l'invention est que le changement de direction des lignes de bit décodées au moyen des conducteurs L qui sont perpendiculaires aux lignes GBLD s'effectue par interconnexion conductrice directe, c'est-à-dire sans élément actif tel que les transistors prévus, par ailleurs, dans les amplificateurs de décodage et dans les cellules mémoire.

Un avantage de la présente invention est qu'elle tire profit de la place laissée disponible par les décodeurs de rangées RDEC et leur circuit de prédécodage pour loger, d'un même côté du circuit mémoire, les étages d'entrée-sortie I/O et les circuits de commande (CONTROL) généraux de la mémoire. Cela est rendu possible dans la mesure où les amplificateurs de lecture CDEC sont désormais logés à l'intérieur de la matrice mémoire proprement dite.

Ainsi, un avantage induit de la présente invention est que, sans augmenter la taille globale de la mémoire, voire même en la diminuant, on dispose d'un circuit dont tous les accès externes sont d'un même côté ce qui simplifie grandement son association avec d'autres circuits dans la réalisation d'un système électronique.

Un autre avantage de la présente invention est qu'en reportant tous les circuits de commande d'un même côté de la mémoire, on réduit l'encombrement global du circuit mémoire.

Un autre avantage de la présente invention est que la proximité "mutuelle" de toutes les fonctions raccourcit les temps de propagation des signaux et, par conséquent, augmente les performances.

En outre, le fait que les sorties des amplificateurs soient interconnectées par colonne impose (par rapport au cas classique de la figure 3) un décodage des sorties des amplificateurs en amont des étages d'entrée-sortie qui ne reçoivent qu'un fil par colonne. Cela réduit considérablement le nombre de fils entre les étages d'entrée-sortie et la matrice mémoire, d'où une diminution du nombre d'adaptateur de niveau (buffer) des étages d'entrée-sortie, donc de la surface et de la consommation.

Par exemple, le décodage des sorties des amplificateurs de lecture s'effectue au moyen de commutateurs de sélection K12ⱼ, K34ⱼ, K12ⱼ₊₁, K34ⱼ₊₁, etc., par exemple en technologie CMOS, respectivement associés aux sorties des amplificateurs A12ⱼ, A34ⱼ, A12ⱼ₊₁, A34ⱼ₊₁, etc. Ces commutateurs permettent même, le cas échéant, de partager un même conducteur de ligne de bit décodée GBLD entre plusieurs colonnes, de préférence voisines. On minimise encore le nombre d'adaptateurs de niveau (buffers) situés aux extrémités de ces fils en entrée des étages d'entrée-sortie. Par souci de clarté, les signaux de commande respectifs des commutateurs n'ont pas été représentés.

On notera que, pour permettre une interconnexion entre les lignes de bit décodées GBLDⱼ, GBLDⱼ₊₁ et les lignes de raccordement respectives Lⱼ, Lⱼ₊₁ aux étages d'entrée-sortie, il est nécessaire de disposer, dans le circuit intégré multicouche dans lequel est formée la mémoire, d'un niveau de métallisation permettant la réalisation des lignes Lⱼ et Lⱼ₊₁ sans gêner le tracé des lignes de mot WL, ni les interconnexions respectives entre les différents constituants du circuit mémoire.

Une première solution envisageable est de prévoir une légère augmentation de l'encombrement en plan du circuit mémoire pour garantir un passage correct de ces différents conducteurs.

Une deuxième solution préférée est de prévoir un niveau de métallisation supplémentaire, pour permettre la réalisation de ces interconnexions supplémentaires.

En pratique, dans une technologie HCMOS6, un niveau (le cinquième niveau) de métallisation est disponible. La mise en oeuvre de l'invention est alors parfaitement compatible avec les procédés classiques. Dans une autre technologie, on pourra ajouter un niveau de métal dédié, ou utiliser un niveau disponible (par exemple, le cinquième ou le sixième en technologie HCMOS7).

Bien entendu, la présente invention est susceptible de diverses variantes et modifications qui apparaîtront à l'homme de l'art. En particulier, la répartition des différents circuits de commande de la mémoire dans la partie latérale qui leur est destinée est fonction des tailles respectives des circuits utilisés, donc de l'application et de l'organisation du réseau mémoire en lui-même.

De plus, bien que l'on ait fait référence dans la description qui précède à des mémoires dynamiques, l'invention s'applique à tout type de mémoire en réseau matriciel organisée en plans (ou sections) mémoire formés, chacun, d'un réseau matriciel. En particulier, l'invention s'applique aux mémoires "repliées" (folded), aux mémoires statiques (SRAM), et aux mémoires mortes ou programmables. L'adaptation des circuits pour la mise en oeuvre de l'invention est à la portée de l'homme du métier à partir des indications fonctionnelles données ci-dessus, pourvu de respecter un tracé des lignes de bit décodées (entre les amplificateurs de lecture/écriture et les étages d'entrée-sortie) sur deux niveaux conducteurs (métalliques) perpendiculaires. Par exemple, pour une mémoire "repliée", on peut considérer que deux sections de cellules mémoire appariées sont imbriquées pour que, pour chaque amplificateur de lecture, les deux lignes de bit locales correspondent à deux lignes voisines. On prévoit alors une rangée d'amplificateurs de lecture entre chaque paire de sections imbriquées.

En outre, on notera que l'invention s'applique également à des cellules mémoires réalisées à base de transistors à canal P. Les adaptations sont alors à la portée de l'homme du métier et correspondent aux adaptations classiques pour passer d'un circuit pour cellules mémoire en transistors à canal N à un circuit pour cellules mémoire en transistor à canal P.

## Revendications

1. Mémoire en circuit intégré comprenant un réseau matriciel de cellules mémoire (1, 1') divisé en plusieurs sections (S), **caractérisée en ce qu'**elle comporte plusieurs rangées d'amplificateurs de décodage de colonne (CDEC) dont les sorties respectives sont interconnectées, par colonne, au moyen d'une ligne de bit décodée, chaque ligne de bit décodée comportant deux tronçons perpendiculaires (GBLD, L) dont un (L) dans le sens des rangées pour relier directement chaque ligne de bit décodée à une entrée d'un étage d'entrée-sortie (I/O) de la mémoire situé à une extrémité des rangées.

2. Mémoire selon la revendication 1, **caractérisée en ce que** le changement de direction entre les deux tronçons (GBLD, L) s'effectue sans élément actif, par interconnexion conductrice directe.

3. Mémoire selon la revendication 1 ou 2, **caractérisée en ce qu'**elle comporte une rangée d'amplificateurs de décodage de colonne (CDEC) pour au plus deux sections (S).

4. Mémoire selon l'une quelconque des revendications 1 à 3, dans laquelle chaque cellule mémoire (1, 1') est constituée d'un transistor (T) associé à un condensateur de stockage (C), **caractérisée en ce que** chaque amplificateur de décodage de colonne (A) est directement relié à une ligne de bit locale (LBL) interconnectant les drains respectifs des transistors des cellules mémoire d'une section (S).

5. Mémoire selon l'une quelconque des revendications 1 à 4, **caractérisée en ce que** tous les circuits (PREDEC, RDEC, I/O, CDEC) d'exploitation des cellules mémoire (1, 1') sont logés dans le même alignement sur le circuit intégré (2').

6. Mémoire selon la revendication 5, **caractérisée en ce que** tous les circuits (PREDEC, RDEC, I/O) d'exploitation des cellules mémoire (1, 1'), à l'exception des amplificateurs de décodage de colonne (CDEC), sont logés de part et d'autre du circuit intégré (2'), aux extrémités des rangées de cellules mémoire.

7. Mémoire selon la revendication 5, **caractérisée en ce que** tous les circuits (PREDEC, RDEC, I/O) d'exploitation des cellules mémoire (1, 1'), à l'exception des amplificateurs de décodage de colonne (CDEC), sont logés d'un seul côté du circuit intégré (2'), à une extrémité des rangées de cellules mémoire.

8. Mémoire selon la revendication 7, **caractérisé en ce que** tous les bus d'entrée-sortie (ADD, DATA, CTR) de la mémoire se trouvent d'un même côté du circuit intégré (2').

9. Mémoire selon l'une quelconque des revendications 1 à 8, **caractérisée en ce que** le nombre de rangées de cellules mémoire (1, 1') par section mémoire (S) est choisi pour respecter un rapport signal/bruit en lecture qui soit supérieur à 1/10 en entrée des amplificateurs de décodage de colonne (CDEC).

## Claims

1. An integrated circuit memory including an array of memory cells (1, 1') divided into several sections (S), **characterized in that** it includes several rows of column decoding amplifiers (CDEC), the respective outputs of which are interconnected, by column, by means of a decoded bit line, each decoded bit line including two perpendicular sections (GBLD, L), one of which (L) is in the row direction to directly connect each decoded bit line to an input of an input-output stage (I/O) of the memory arranged at one end of the rows.

2. The memory according to claim 1, **characterized in that** the direction change between the two sections is made without an active element, through a direct conductive interconnection.

3. The memory of claim 1 or 2, **characterized in that** it includes one row of column decoding amplifiers (CDEC) for at most two sections (S).

4. The memory of any of claims 1 to 3, wherein each memory cell (1, 1') is formed of a transistor (T) associated with a storage capacitor (C) , **characterized in that** each column decoding amplifier (A) is directly connected to a local bit line (LBL) interconnecting the respective drains of the transistors of the memory cells of a section (S).

5. The memory of any of claims 1 to 4, **characterized in that** all the circuits (PREDEC, RDEC, I/O, CDEC) of exploitation of the memory cells (1, 1') are housed in the same alignment on the integrated circuit (2').

6. The memory of claim 5, **characterized in that** all the circuits (PREDEC, RDEC, I/O) of exploitation of the memory cells (1, 1'), except for the column decoding amplifiers (CDEC), are housed on either side of the integrated circuit (2'), at the ends of the memory cell rows.

7. The memory of claim 5, **characterized in that** all the circuits (PREDEC, RDEC, I/O) of exploitation of the memory cells (1, 1'), except for the column decoding amplifiers (CDEC), are housed on a single side of the integrated circuit (2'), at one end of the memory cell rows.

8. The memory of claim 7, **characterized in that** all memory input-output buses (ADD, DATA, CTR) are on a same side of the integrated circuit (2').

9. The memory of any of claims 1 to 8, **characterized in that** the number of rows of memory cells (1, 1') per memory section (S) is chosen to respect a signal-to-noise ratio in the read mode which is greater than 1/10 at the input of the column decoding amplifiers (CDEC).

## Patentansprüche

1. Ein integrierter Schaltkreisspeicher, der ein Array bzw. Anordnung von Speicherzellen (1,1') aufweist, das in mehrere Abschnitte (S) aufgeteilt ist, **gekennzeichnet dadurch dass** es mehrere Reihen bzw. Zeilen mit Spaltendecodierverstärkern (column decoding amplifiers, CDEC) umfasst, wobei deren entsprechende Ausgänge spaltenweise miteinander verbunden sind und zwar mittels einer decodierten Bitleitung, wobei jede decodierte Bitleitung zwei rechtwinklige Abschnitte (GBLD, L) aufweist, von denen einer (L) in der Zeilenrichtung ist, um jede decodierte Bitleitung direkt mit einem Eingang einer Ein-Ausgabe-Stufe (I/O) des Speichers, die an einem Ende der Zeilen angeordnet ist, zu verbinden.

2. Der Speicher gemäß Anspruch 1, **dadurch gekennzeichnet, dass** die Richtungsänderung zwischen den zwei Abschnitten ohne ein aktives Element durchgeführt wird, und zwar durch eine direkt leitende Zusammenschaltung bzw. Verbindung.

3. Speicher gemäß Anspruch 1 oder 2, **dadurch gekennzeichnet, dass** er eine Zeile mit Spaltendecodierverstärkern (CDEC) für maximal zwei Abschnitte (S) umfasst.

4. Speicher nach einem der Ansprüche 1 bis 3, wobei jede Speicherzelle (1, 1') durch einen Transistor (T) gebildet wird, der mit einem Speicherkondensator (C) assoziiert ist, **dadurch gekennzeichnet, dass** jeder Spaltendecodierverstärker (A) direkt mit einer lokalen Bitleitung (local bit line, LBL) verbunden ist, die die entsprechenden Ableitungen der Transistoren der Speicherzellen eines Abschnitts (S) zusammenschaltet.

5. Speicher nach einem der Ansprüche 1 bis 4, **dadurch gekennzeichnet dass** alle die Schaltkreise (PREDEC, RDEC, I/O, CDEC) der Nutzung der Speicherzellen (1, 1') in der gleichen Ausrichtung auf dem integrierten Schaltkreis (2') angeordnet sind.

6. Speicher nach Anspruch 5, **dadurch gekennzeichnet, dass** sämtliche Schaltkreise (PREDEC, RDEC, I/O) der Nutzung der Speicherzellen (1, 1') mit Ausnahme der Spaltendecodierverstärker (CDEC) auf beiden Seiten der integrierten Schaltung (2') angeordnet sind und zwar an den Enden der Speicherzellenzeilen.

7. Speicher nach Anspruch 5, **dadurch gekennzeichnet, dass** sämtliche Schaltkreise (PREDEC, RDEC, I/O) der Nutzung der Speicherzellen (1, 1') mit Ausnahme der Spaltendecodierverstärker (CDEC) auf einer einzigen Seite der integrierten Schaltung (2') angeordnet sind, und zwar an einem Ende der Speicherzellenzeilen.

8. Speicher nach Anspruch 7, **dadurch gekennzeichnet, dass** alle Speicher-Ein-Ausgabe-Busse (ADD, DATA, CTR) auf der gleichen Seite der integrierten Schaltung (2') sind.

9. Speicher nach irgendeinem der Ansprüche 1 bis 8, **dadurch gekennzeichnet, dass** die Anzahl der Zeilen der Speicherzellen (1, 1') pro Speicherabschnitt (S) gemäß einem Signal-zu-Rausch-Verhältnis in den Lesemodus gewählt wird, das größer ist als 1/10 am Eingang der Spaltendecodierverstärker (CDEC).
